# EUROPEAN PATENT SPECIFICATION

(11) **EP 0 434 414 B1**
(45) Date of publication and mention of the grant of the patent: **27.04.1994**
(21) Application number: 90313963.2
(22) Date of filing: 19.12.1990
(51) Int. Cl.: H01L 23/32, E05D 1/06

(54) **IC carrier**
Halterung für integrierte Schaltung
Support de circuit intégré

(30) Priority: 22.12.1989 JP 333999/89
(43) Date of publication of application: 26.06.1991
(73) Proprietor: Yamaichi Electronics Co., Ltd., Ohta-ku Tokyo (JP)
(72) Inventor: Matsuoka, Noriyuki, Tokyo (JP); Uratsuji, Kazumi, Tokyo (JP)
(74) Representative: Ben-Nathan, Laurence Albert

(56) References cited:
- EP-A- 0 083 151
- DE-C- 1 046 909
- US-A- 4 007 479
- US-A- 4 724 579

## Description

### BACKGROUND OF THE INVENTION

### Field of the Invention

This invention relates to an IC carrier comprising a base and a cover pivotably attached to the base.

### Brief Description of the Prior Art

An IC carrier disclosed in USP4007479 comprises a base, and a cover pivotably connected to the base through an integrally molded hinge. The cover is not removably attached to the base.

IC carriers disclosed in Japanese Utility Model Early laid-open Publication No. Sho 60-146089 and Japanese Utility Model Publication No. Sho 60-10310 are designed such that a canceled state of the shaft coupling is formed in a position where a cover is attached to a base.

The latter, for example, has such a construction as that the shaft coupling is naturally canceled in a pivotal position where the pivot shaft is fitted to a cut-out portion of a key-groove.

One of the above-mentioned conventional IC carriers has such a shortcoming as that the cover cannot be attached to and removed from the base, while the other has the advantage that the cover can be removably attached to the base but it has such a shortcoming as that the shaft coupling is naturally canceled in the position where the cover is attached to the base.

The present invention has been accomplished in view of the above.

### SUMMARY OF THE INVENTION

It is therefore an object of the present invention to provide an IC carrier, in which the cover can easily be attached to and removed from the cover, the shaft coupling is not accidentally canceled after the cover has been attached to the base, and such shaft coupling can easily be assembled.

To achieve the above object, according to the present invention, there is essentially provided an IC carrier comprising a base and a cover pivotably attached to said base through a shaft coupling, an IC being held by closing said cover relative to said base, one end of said cover being provided with a plurality of shafts forming said shaft coupling and arranged at spaces in a projecting fashion, one end of said base being provided with a plurality of short recess portions shorter than the length of said shafts forming said shaft coupling and a plurality of recess portions equal to or longer than the length of said shafts, said short and long recess portions being arranged at spaces, one ends of said recess portions being provided with shaft inserting portions for receiving tips of said shafts, said cover being able to be bent in the thick direction thereof, said shafts being able to be inclined in accordance with the bending motion of said cover, said shafts corresponding to said long recess portions equal to or longer than the length of said shafts being inserted into said shaft inserting portions at one ends of said recess portions via said recess portions, said shafts corresponding to said short recess portions shorter than the length of said shafts being inserted into said shaft inserting portions at one ends of said short recess portions shorter than the length of said shafts when said shafts are inclined owing to bending motion of said cover, said shafts being brought into engagement with said recess portions owing to restoring motion of said cover.

In the present invention, the shafts mounted to the cover are inclined in accordance with the bending motion of the cover in the backward direction and inserted into the shaft inserting portions at one end portions of the short recess portions shorter than the length of the shafts, and then brought into engagement with the recess portions by the restoring motion of the cover to assemble the shaft coupling. The shaft coupling can be disassembled by removing the shafts from the shaft inserting portions of the short recess portions shorter than the length of the shafts while bending the cover again in the backward direction. The cover cannot be attached to nor removed from the base unless the cover is bent in the backward direction.

Accordingly, it never happens that the shaft coupling is undesirably canceled within a range where the cover can be pivoted in a normal state of use. On the contrary, the shaft coupling can easily be canceled simply by bending the cover in the backward direction.

The above and other objects, features and advantages of the present invention will become more apparent upon an understanding of the following detailed description of the embodiment with reference to the accompanying drawings.

### BRIEF DESCRIPTION OF THE DRAWINGS

Fig. 1 is a perspective view of an IC carrier with a cover opened according to one embodiment of the present invention;
Fig. 2 is a sectional view of the above;
Fig. 3 is a perspective view of the IC carrier with the cover closed;
Fig. 4 is a plan view of a base of the above;
Fig. 5 is a sectional view taken on line A-A of Fig. 4;
Fig. 6 is a plan view of the cover;
Fig. 7 is a perspective view of a coupling portion of a shaft of the base;
Fig. 8 is a plan view of the above;
Fig. 9(A) is a sectional view taken on line B-B of Fig. 8;
Fig. 9(B) is a sectional view taken on line C-C of Fig. 8;
Fig. 9(C) is a sectional view taken on line D-D of Fig. 8;
Fig. 9(D) is a sectional view taken on line E-E of Fig. 8;
Fig. 9(E) is a sectional view taken on line F-F of Fig. 8;
Fig. 9(F) is a sectional view taken on line G-G of Fig 8;
Figs. 10(A) through 10(C) are plan views for explaining the steps for forming a shaft coupling by conforming the shaft portion to a recess portion;
Fig. 11 is a plan view showing the IC carrier with an IC loaded thereon; and
Fig. 12 is a sectional view showing an IC socket with the IC carrier loaded thereon.

### DETAILED DESCRIPTION OF THE EMBODIMENT

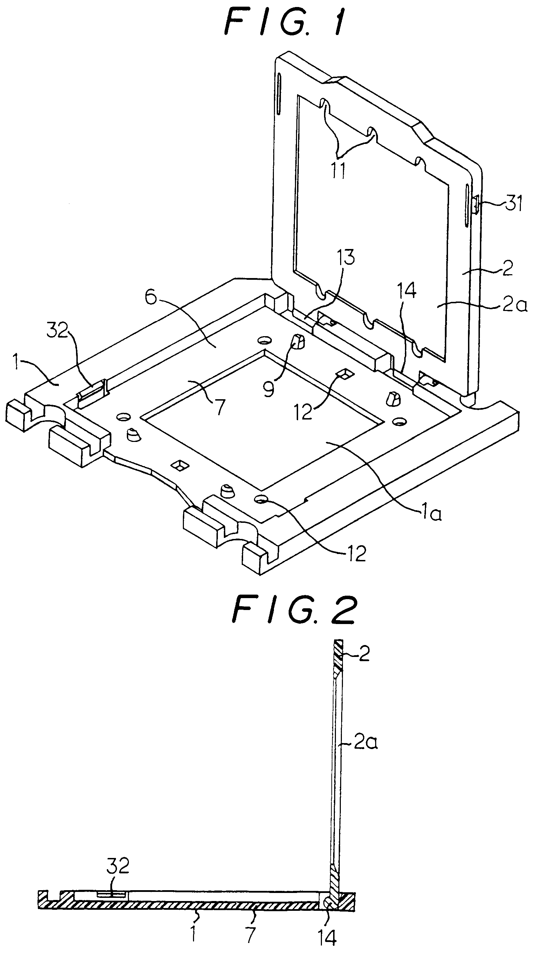

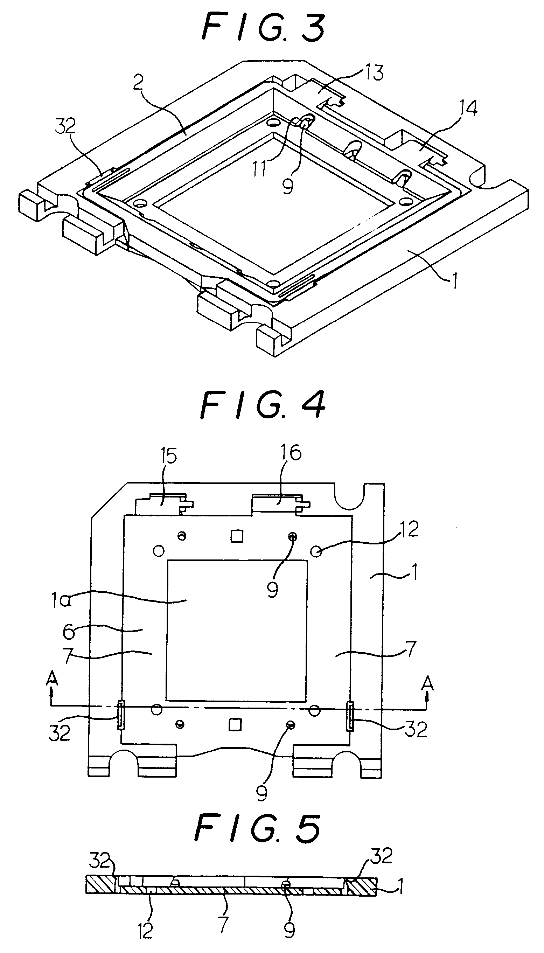

Figs. 1 through 12 show one embodiment of the present invention. This embodiment exemplifies a thin and flat IC carrier which is designed for the use of an IC 5 holding an IC chip 4 by serving a film 3 as shown in Fig. 11 as a carrier.

The IC carrier comprises a base 1 and a cover 2, the base 1 is formed in a square frame plate, an IC accommodating section 6 is defined in an inner area along an opening portion 1a of the frame plate, a frame plate portion forming a bottom plate of the IC accommodating section 6 is served as a supporting plate 7 for supporting a peripheral portion of the IC 5, the supporting plate 7 is provided with pins 9 projecting therefrom and adapted to position the IC 5, and the IC positioning pins 9 are inserted into holes 8 for positioning the IC 5 to hold the IC 5 on the base 1 while loading the IC 5 in the IC accommodating section 6 of the base 1. The supporting plate 7 is provided with positioning holes 12 into which carrier positioning pins disposed on the side of an IC socket 10 shown in Fig. 12 are to be inserted. On the other hand, the cover 2 is formed of a square frame plate, the square frame plate is engaged with the IC accommodating section 6 to press the peripheral portion of the IC 5, and positioning holes 11, into which the IC carrier positioning pins disposed on the side of the IC socket 10 and the IC positioning pins 9 are to be inserted, are formed in a marginal portion along the opening portion 2a of the square frame plate.

As a shaft coupler for pivotally connecting the cover 2 to the base 1 so that the cover 2 can be opened and closed (pivotable), a plurality of shafts 13 and 14 are arranged at one end of the cover 2 at spaces in a projecting fashion.

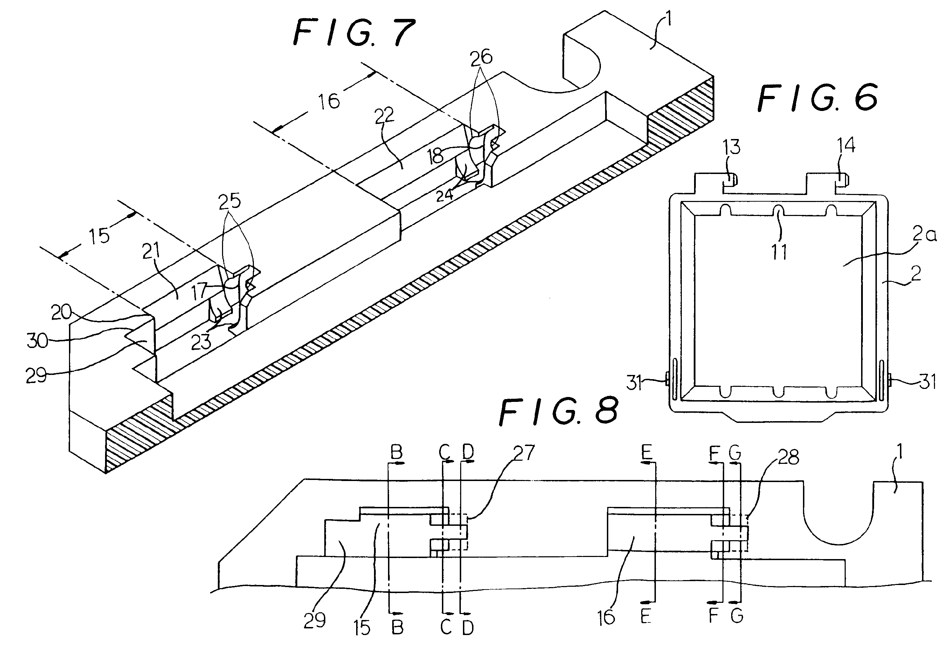

The shaft 13, as shown in Fig. 6, has a coaxis, and two of such shafts, for example, arranged in such a manner as to be projected in the same direction perpendicular to the pivoting direction of the cover 2.

On the other hand, a plurality of short recess portions 15 shorter than the length of the shafts forming the shaft coupling and long recess portions 16 equal to or longer than the length of the shafts are formed in one end of the base 1 at spaces in such a manner as to correspond to the shafts 13 and 14, and one ends of the recess portions 15 and 16 are provided with a plurality of shaft inserting portions 17 and 18 for receiving the tips of the shafts 13 and 14.

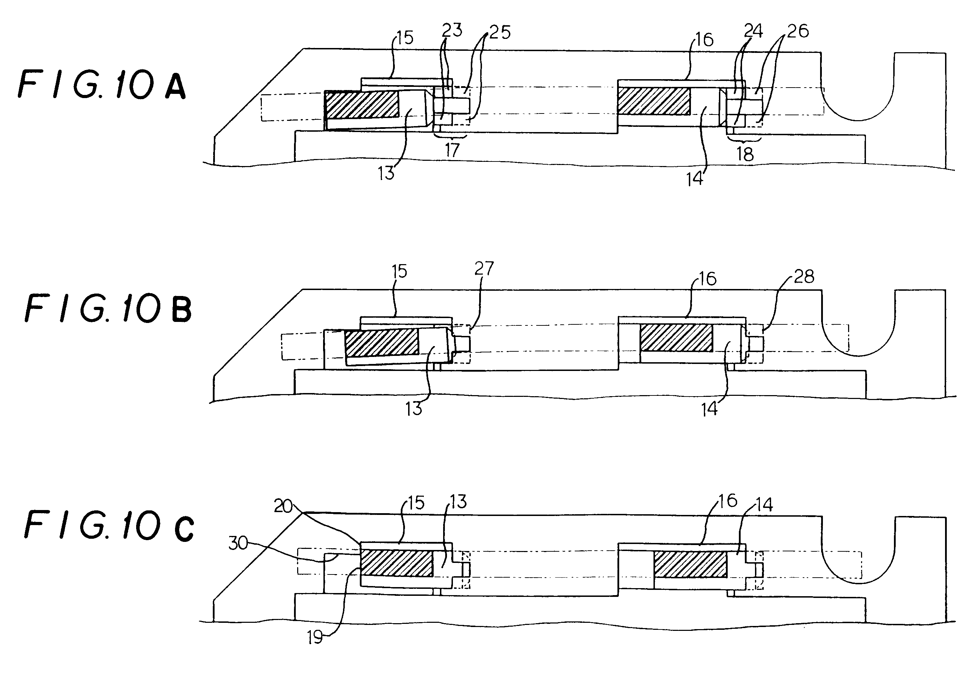

As is shown in Figs. 10(A) ad 10(B), the cover 2 can be backwardly bent in the thick direction thereof, and by backwardly bending the cover 2, the shafts 13 and 14 can be inclined in the bending direction of the cover 2.

As is shown in Figs. 10(A), 10(B) and 10(C), the shaft 14 corresponding to the long recess portion 16 longer than the length of the shafts is inserted into the shaft inserting portion 18 at one end of the recess portion 16 via the recess portion 16. On the other hand, as is shown in Fig. 10(A) and 10(B), the shaft 13 corresponding to the short recess portion 15 shorter than the length of the shafts is inserted into the shaft inserting portion 17 at one end of the short recess portion 15 shorter than the length of the shafts when the shaft 13 is in its inclined state owing to bending motion of the cover 2 in the backward direction, and by restoring the bending cover 2 to its original state upon completion of the insertion of the shaft 13 as shown in Fig. 10(C), the shaft 13 is engaged in the recess portion 15, and an end face 19 of a basic end portion of the shaft 13 is contacted with the other end 20 (end face on the opposite side with respect to the shaft inserting portion 17) of the recess portion 15 in order to prevent the shafts 13 and 14 from slipping out of the shaft inserting portions 17 and 18. At that time, the shaft 14 is loosely inserted into the shaft inserting portion 18 within the recess portion 16 with a play formed in the slipping-out direction.

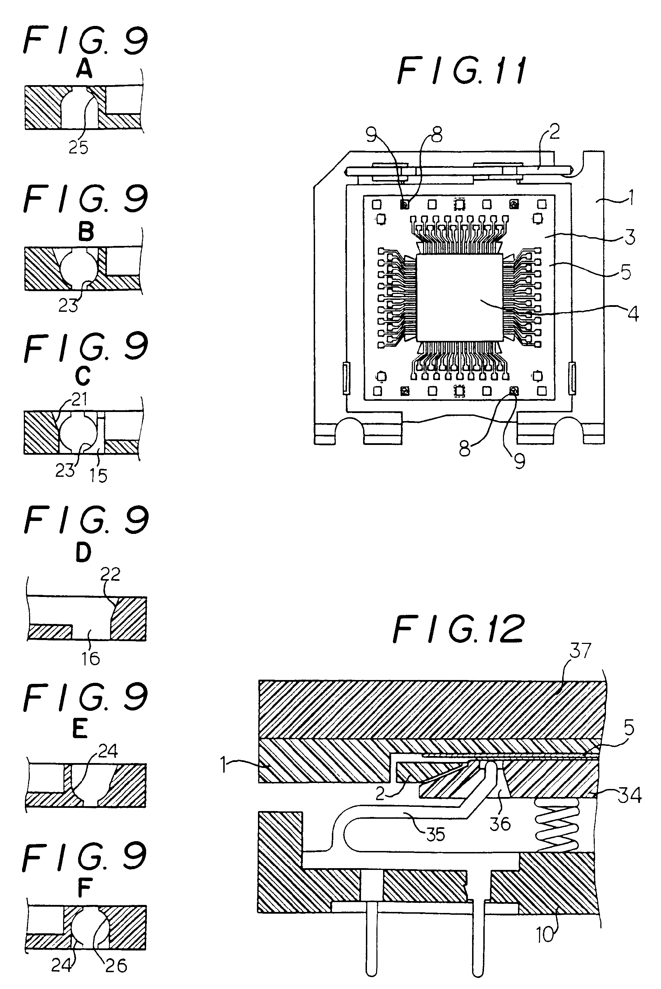

The shaft inserting portions 17 and 18 are formed in the same construction which is shown in Figs. 9(A) through 9(F).

As is shown in Fig. 9(A) and 9(D), the recess portions 15 and 16 are provided with inclined surfaces 21 and 22 formed at entrance portions of the shafts 13 and 14 and adapted to enlarge the entrance portions. End portions of the recess portions 15 and 16 at the entrance portions of the shaft inserting portions, as shown in Figs. 9(B) and 9(E), are provided with arcuate bearing portions for holding arcuate surfaces of the bottom portions of the circular shafts 13 and 14 which are engaged with the recess portions 15 and 16, and also with arcuate bearing portions 25 and 26 for holding upper arcuate surfaces of the shafts 13 and 14 by receiving terminal ends of the shafts 13 and 14 penetrating the bearing portions 23 and 24 as shown in Figs. 9(C) and 9(F) and further with bottom surfaces 27 and 28 to be contacted with and stopped by the end faces of the shafts 13 and 14 in order to restrict the movement of the shafts 13 and 14 in the same direction and to restrict play in the radial direction of the shafts 13 and 14 by the shaft inserting portions 23, 24 and 25, 26.

The short recess portion 15 shorter the length of the shaft is connected with an enlarged recess portion 29 longer than the shaft formed at the entrance portion of the shaft 13. The enlarged recess portion 29 is long on the opposite side with respect to the shaft inserting portion 17 of the recess portion 15, and a step portion 30 is formed between the recess portion 15 and the enlarged recess portion 29 there. As is shown in Figs. 10(A) and 10(B), the shaft 13 is inclined in accordance with the backward bending motion of the cover 2 and brought into engagement with the enlarged recess portion 29, the tip of the shaft 13, while supporting the basic end of the shaft 13 by the step portion 30, is inclined and inserted into the shaft inserting portion 17, and by restoring the backwardly bending state of the cover 2, the shaft 13 is brought into engagement with the recess portion 15. That is to say, if the step 30, which is necessarily formed at the entrance portion of the recess portion 15, exists, it can be practiced without a provision of the enlarged recess portion 29.

Furthermore, in the above-mentioned embodiment, the recess portions 15 and 16 are opened up on the side of an upper surface of the end portion of the base 1, the cover 2, as shown in Figs. 1, 2 and 10, is backwardly bent in the thick direction thereof in order to be brought into an erected state with respect to the base 1, and in that state, the shafts 13 and 14 are held to the recess portions 15 and 16 to realize the above-mentioned engagement. As a modified embodiment, it may be designed such that the recess portions 15 and 16 are opened up on the side of the end faces of the recess portions 15 and 16, and the shafts 13 and 14 are engaged into the recess portions 15 and 16 from the end face side.

In this way, the cover 2 is pivotably mounted to the base 1, a shaft coupling, which is not easily slipped out at any pivoting position is formed, and by closing the cover 2 relative to the base 1, the IC 5 can be held therebetween. In order to lock the holding state of the IC, for example, the cover 2 is engaged in the IC accommodating section 6, engaging projections 31 formed in the vicinity of the free end portion of the both sides of the cover 2 are snap engaged with projections 32 formed on the corresponding both sides of the IC accommodating section 6, thereby to prevent the cover 2 from being accidentally pivoted in the opening direction.

As is shown in Fig. 12, the carrier carrying the IC 5 is loaded on a table 34, which can be resiliently moved upward and downward, of the socket 10, a contact 35 of the socket 10 is inserted into a contact positioning hole 36, and by intimately contacting the presser plate 37 with the socket 10 to press the base 1, the contact 35 is resiliently contacted with a contacting piece of the IC 5 through the opening portion 2a of the cover 2 as a reaction.

According to the present invention, the cover causes the shafts, while inclining the shafts owing to the backward bending motion of the cover, to be inserted into shaft inserting portions of corresponding short recess portions shorter than the length of the shafts, and the shafts are engaged in the recessed portions by the restoring motion of the cover to enhance an easy assembly of the shaft coupling. The shaft coupling can easily be disassembled by removing the shafts from the shaft inserting portions of the short recess portions shorter than the length of the shafts while bending the cover again in the backward direction.

Owing to the foregoing arrangement, the cover cannot be inserted into nor removed from the recess portions unless the cover is bent backwardly. Accordingly, there is no such fear as to cause undesirable cancellation of the shaft coupling within a range of a pivotal movement of the cover. If the cover is bent backwardly while exhibiting the above-mentioned effect, cancellation of the shaft coupling can easily be realized.

## Claims

1. An IC carrier comprising a base (1) and a cover (2) pivotably attached to said base through a shaft coupling, for holding an IC (5) by closing said cover relative to said base, one end of said cover (2) being provided with a plurality of shafts (13,14) forming said shaft coupling and arranged at spaced positions in a projecting fashion, one end of said base (1) being provided with a plurality of recess portions (15,16) including a short recess portion shorter (15) than the length of said shafts (13,14) forming said shaft coupling and a long recess portion equal to or longer than the length of said shafts (13,14), said short and long recess portions (15,16) being arranged at spaced positions, one end of said recess portions being provided with shaft inserting portions (17,18) for receiving tips of said shafts (13,14), said cover (2) being able to be bent in the thick direction thereof, said shafts (13,14) being able to be inclined in accordance with the bending motion of said cover, said shaft(s) (14) corresponding to said long recess portion(s) (16) equal to or longer than the length of said shafts being inserted into said shaft inserting portions (18) at one end of said recess portions via said recess portions (16), said shaft(s) (13) corresponding to said short recess portion(s) (15) shorter than the length of said shafts being inserted into said shaft inserting portion(s) (17) at one end of said short recess portion(s) (15) shorter than the length of said shafts when that shaft is inclined owing to bending motion of said cover, said shafts (13,14) being brought into engagement with said recess portions (15,16) owing to restoring motion of said cover (2).

2. An IC carrier according to Claim 1 wherein said short recess portion (13) opens into an associated enlarged recess portion (29) longer than said shafts (13,14) and extending beyond the end of said short recess portion at the end thereof remote from the shaft inserting portion (17) associated with said short recess portion (13).

3. An IC carrier according to Claim 2 wherein a step (30) is formed at said remote end of said short recess portion (13) between the end thereof and the corresponding end of said associated enlarged recess portion (29).

4. An IC carrier according to any one of Claims 1 - 3, wherein end portions of said recess portions (15,16) adjacent the associated shaft inserting portions (17,18), are provided with arcuate bearing portions for seating bottom portions of the respective shafts.

5. An IC carrier according to any one of Claims 1 - 4 wherein said shaft inserting portions (17,18) are provided with arcuate bearing portions for seating upper portions of the respective shafts.

6. An IC carrier according to any one of Claims 1 - 5 wherein said recess portions (15,16) are formed with inclined surfaces (21,22) along side edges thereof to enlarge entry portions into the respective recess portions.

## Patentansprüche

1. Halterung für eine integrierte Schaltung, bestehend aus einem Aufnahmebehälter (1) für die integrierte Schaltung (5) und einem über eine Zapfenlagerung verschwenkbar daran angelenkten, die integrierte Schaltung (5) in Schließlage festlegenden Deckel (2), der entlang einer Kante mit einer Mehrzahl von beabstandeten, über die Kante vorspringenden Lagerzapfen (13, 14) versehen ist und der Aufnahmebehälter (1) dementsprechend in einem Kantenbereich mit dementsprechend beabstandeten Rücksprüngen (15, 16), deren einer (15) kürzer ist als die Lagerzapfen (13, 14) und deren anderer (16) eine Länge aufweist, die gleich oder größer ist als die Länge der Lagerzapfen (13, 14), wobei die Rücksprünge (15, 16) einen Ends in die freie Enden der Lagerzapfen (13, 14) aufnehmende Lagerstellen (17, 18) übergehen, mit einem um eine die idielle Zapfenachse querende Achse biegbaren Deckel (2) mit einhergehender Schrägstellung der Lagerzapfen (13, 14), so daß bei um die die idielle Zapfenachse querende Biegeachse gebogenem Deckel der dem länger ausgelegten Rücksprung (16) zuzuordnende Lagerzapfen (14) anliegend an die von der in diesem Rücksprung (16) ausgebildeten Lagerstelle (18) abgekehrten Wandung des Rücksprungs (16) in den Rücksprung (16) einfügbar ist und der dem kürzer ausgelegten Rücksprung (15) zuzuordnende Lagerzapfen (13) in diesen Rücksprung (15) ebenfalls anliegend an die von der in diesem Rücksprung (15) ausgebildeten Lagerstelle (17) abgekehrte Wandung des Rücksprungs (15) eingefügbar ist und bei Aufhebung der dem Deckel (2) vermittelten Biegung die freien Enden der Lagerzapfen (13, 14) sich in die in den Rücksprüngen (19, 16) ausgebildeten Lagerstellen (17, 18) für die freien Ende der Lagerzapfen (13, 14) einfügen.

2. Halterung für eine integrierte Schaltung nach Anspruch 1, dadurch gekennzeichnet, daß der kürzer ausgelegte Rücksprung (15) im Aufnahmebehälter (1) in einem Rücksprung (29) ausgebildet ist, der eine größere Länge aufweist als die Lagerzapfen (13, 14), wobei der Überstand des Rücksprungs (29) über den Rücksprung (15) auf der von der Lagerstelle (17) des Rücksprungs (15) abgekehrten Seite des Rücksprungs (15) ausgebildet ist.

3. Halterung für eine integrierte Schaltung nach Anspruch 2, dadurch gekennzeichnet, daß zwischen dem Überstand des Rücksprungs (29) über den darin ausgebildeten Rücksprung (15) eine Stufe (30) ausgebildet ist.

4. Halterung für eine intergrierte Schaltung nach einem der Ansprüche 1 bis 3, dadurch gekennzeichnet, daß an den an die Lagerstellen (17, 18) für die freien Enden der Lagerzapfen (13, 14) angrenzenden Wandbereichen der Rücksprünge (15, 16) im Aufnahmebehälter (1) die Lagerzapfen (13, 14) unterfangende Lagerböcke (23, 24) mit einer der Umfangsfläche der Lagerzapfen (13, 14) entsprechenden Lagerfläche angeformt sind.

5. Halterung für eine integrierte Schaltung nach einem der Ansprüche 1 bis 4, dadurch gekennzeichnet, daß in den Lagerstellen (17, 18) für die freien Ende der Lagerzapfen (13, 14) gegen den Umfang der freien Enden der Lagerzapfen (13, 14) zur Anlage kommende Stützflächen ausgebildet sind.

6. Halterung für eine integrierte Schaltung nach einem der Ansprüche 1 bis 5, dadurch gekennzeichnet, daß die Rücksprünge (15, 16) im Aufnahmebehälter (1) den Zugang zu den Rücksprüngen vergrößernde einfallende Wandungsbereiche (21, 22) aufweisen.

## Revendications

1. Support de circuit intégré comportant un socle (1) et un capot (2) lié de manière pivotante au socle au moyen d'un accouplement par axe, pour maintenir un circuit intégré (5) en refermant le capot par rapport au socle, une extrémité du capot (2) étant munie d'une pluralité d'axes (13, 14) constituant l'accouplement par axe et disposés en saillie dans des positions espacées, une extrémité du socle étant munie d'une pluralité de zones en retrait (15, 16) incluant une zone en retrait courte, plus courte (15) que la longueur des axes (13, 14) formant l'accouplement par axe et une zone en retrait longue égale ou supérieure à la longueur des axes (13, 14), les zones en retrait courtes et longues (15, 16) étant disposées dans des positions espacées, une extrémité des zones en retrait étant munie de zones d'insertion d'axe (17, 18) pour recevoir les embouts des axes (13, 14), le capot (2) pouvant être courbé dans la direction de son épaisseur, les axes (13, 14) pouvant être incurvés en concordance avec le mouvement de courbure du capot, les axes (14) correspondant aux zones en retrait longues (16) égales ou supérieures à la longueur des axes, étant insérés dans les zones d'insertion d'axe (18) à une extrémité des zones en retrait, via les zones en retrait (16), les axes (13) correspondant aux zones en retrait courtes (15) plus courtes que la longueur des axes, étant insérés dans les zones d'insertion d'axe (17) à une extrémité des zones en retrait courtes plus courtes que la longueur des axes lorsque cet axe est incliné du fait du mouvement de courbure du capot, les axes (13, 14) étant amenés en contact avec les zones en retrait (15, 16) du fait du mouvement de retour en place du capot (2).

2. Support de circuit intégré selon la revendication 1, caractérisé en ce que la zone en retrait courte (13) débouche dans une zone en retrait élargie associée (29) plus longue que les axes (13, 14) et s'étendant au-delà de l'extrémité de la zone en retrait courte, à son extrémité opposée à la zone d'insertion d'arbre (17) associée à la zone en retrait courte (13).

3. Support de circuit intégré selon la revendication 2, caractérisé en ce qu'une marche (30) est formée à l'extrémité distante de la zone en retrait courte (13) entre son extrémité et l'extrémité correspondante de la zone en retrait élargie associée (29).

4. Support de circuit intégré selon l'une quelconque des revendications 1 à 3, caractérisé en ce que les zones d'extrémités des zones en retrait (15, 16) voisines des zones d'insertion d'axe associées (17, 18) sont munies de zones de palier incurvées pour servir d'appui aux zones inférieures des axes respectifs.

5. Support de circuit intégré selon l'une quelconque des revendications 1 à 4, caractérisé en ce que les zones d'insertion d'arbre (17, 18) sont munies de zones de palier incurvées pour servir d'appui aux zones supérieures des axes respectifs.

6. Support de circuit intégré selon l'une quelconque des revendications 1 à 5, caractérisé en ce que les zones en retrait (15, 16) sont munies de surfaces inclinées (21, 22) le long de leurs bords latéraux pour agrandir les zones d'entrée dans les zones en retrait respectives.
